# EUROPEAN PATENT APPLICATION

(11) **EP 2 357 750 A1**
(43) Date of publication of application: **17.08.2011**
(21) Application number: 10189279.2
(22) Date of filing: 28.10.2010
(51) Int. Cl.: H04L 1/00, H03M 13/27, H04N 5/44, G06F 13/16

(54) **Authentication module, electric device, and interleaved signal restoring method**

(30) Priority: 22.12.2009 JP 2009291487
(71) Applicant: Kabushiki Kaisha Toshiba, Tokyo 105-8001 (JP)
(72) Inventor: Nagasaka, Toshiro, Tokyo 105-8001 (JP)
(74) Representative: Henkel, Feiler & Hänzel

(57) **Abstract**

In one embodiment, an authenticate module (12) includes: a memory module (121a) that a plurality of data elements of an input interleaved signal are written to and read from; and a memory access controller (121b) configured to write the data elements of the input interleaved signal to the memory module (121a) sequentially in accordance with address information in a specific writing order commonly set between different signal formats of interleaved signals, and read the data elements written to the memory module (121a) from the memory module (121a) sequentially in accordance with address information in a specific reading order commonly set between the different signal formats, and output the read data elements as a restore signal.

## Description

### FIELD

Embodiments described herein relate generally to a authentication module, an electric device, and an interleaved signal restoring method.

### BACKGROUND

Conventionally, an interleaved signal transmission and reception system is known in which an interleaved signal capable of distributing transmission errors occurred in a transmission signal transmitted on a radio wave (a carrier wave) is used.

Specifically, as such kind of interleaved signal transmission and reception system, a following television system is known. That is, in the television system, an interleaved signal obtained by interleaving a transmission signal including a command and an ID in a predetermined signal format is transmitted on a radio wave at a side of an interleaved signal transmitter such as a remote controller, and the interleaved signal extracted from the radio wave received at a side of an interleaved signal receiver such as a television receiver is restored.

As the signal format, a plurality of types of signal formats which have different advantages, respectively, are provided. One example of the signal formats is a signal format having a characteristic that has a strong authentication capability and does not have a high error correction capability to correct communication errors (transmission errors). Another example of the signal formats is a signal format having a characteristic that has a weak authentication capability and has a high error correction capability to correct communication errors.

Because of this, conventionally, in the above mentioned television system, an optimal signal format is selected from a plurality types of signal formats in accordance with a condition of a communication environment at the side of the remote controller (the interleaved signal transmitter). And in order that a plurality of types of interleaved signals obtained by interleaving in the different signal formats can be restored at a side of the television receiver (the interleaved signal receiver), restoring modules each of which performs a restoring process only for one of the different signal formats are mounted on a mounted module such as an authentication module.

According to the above mentioned interleaved signal transmission and reception system, the same number of restoring modules as the number of the types of signal formats supported at the side of the interleaved signal receiver are mounted. For this reason, it is difficult to downsize an authentication module (a mounted module) on which the restoring modules are mounted, and an electric device on which the authentication module is mounted. Especially, as the number of the types of signal formats supported at the side of the interleaved signal receiver increases, the authentication module and the electric device are necessitated to be larger.

Also, if the sizes of the authentication module (the mounted module) and the electric device are increased, manufacturing costs of the authentication module and the electric device are increased.

### BRIEF DESCRIPTION OF THE SEVERAL VIEWS OF THE DRAWINGS

A general architecture that implements the various features of the invention will now be described with reference to the drawings. The drawings and the associated descriptions are provided to illustrate embodiments of the invention and not to limit the scope of the invention.

FIG. 1 is an exemplary block diagram of a television system according to an embodiment;
FIG. 2A is an exemplary schematic view of a data structure of a transmission signal before being interleaved to generate an interleaved signal having a signal format (A) in the embodiment;
FIG. 2B is an exemplary schematic view of a data structure of the interleaved signal having the signal format (A) in the embodiment;
FIG. 3A is an exemplary schematic view of a data structure of a transmission signal before being interleaved to generate an interleaved signal having a signal format (B) in the embodiment;
FIG. 3B is an exemplary schematic view of a data structure of the interleaved signal having the signal format (B) in the embodiment;
FIG. 4 is an exemplary flow chart of interleaved signal transmission processing by a remote controller in the embodiment;
FIG. 5 is an exemplary flow chart of an interleaved signal reception processing by a television receiver in the embodiment;
FIG. 6 is an exemplary flow chart of a restoring processing at S12 of FIG. 5;
FIG. 7 is an exemplary schematic view illustrating of a restoring processing of the interleaved signal having the signal format (A) in the embodiment;
FIG. 8A is an exemplary schematic view of a data structure of an incorrect restore signal of the interleaved signal having the signal format (A) in the embodiment;
FIG. 8B is an exemplary schematic view of a data structure of a correct restore signal of the interleaved signal having the signal format (A) in the embodiment;
FIG. 9A is an exemplary schematic view of a data structure of an ID data output from an error determination module in the embodiment with respect to the correct restore signal illustrated in FIG. 8B;
FIG. 9B is an exemplary schematic view of a data structure of a command data output from an error determination module in the embodiment with respect to the correct restore signal illustrated in FIG. 8B;
FIG. 10 is an exemplary schematic view illustrating of a restoring processing of the interleaved signal having the signal format (B) in the embodiment;
FIG. 11A is an exemplary schematic view of a data structure of an incorrect restore signal of the interleaved signal having the signal format (B) in the embodiment;
FIG. 11B is an exemplary schematic view of a data structure of a correct restore signal of the interleaved signal having the signal format (B) in the embodiment;
FIG. 12A is an exemplary schematic view of a data structure of an ID data output from an error determination module in the embodiment with respect to the correct restore signal illustrated in FIG. 11B; and
FIG. 12B is an exemplary schematic view of a data structure of a command data output from an error determination module in the embodiment with respect to the correct restore signal illustrated in FIG. 11B.

### DETAILED DESCRIPTION

In general, according to one embodiment, an authentication module comprises: a memory module, and a memory access controller. A plurality of data elements of an input interleaved signal are written to and read from the memory module. The memory access controller is configured to write the data elements of the input interleaved signal to the memory module sequentially in accordance with address information in a specific writing order commonly set between different signal formats of interleaved signals, and read the data elements written to the memory module from the memory module sequentially in accordance with address information in a specific reading order commonly set between the different signal formats, and output the read data elements as a restore signal.

According to another embodiment, an electric device comprises: a memory module that a plurality of data elements of an input interleaved signal are written to and read from; and a memory access controller configured to write the data elements of the input interleaved signal to the memory module sequentially in accordance with address information in a specific writing order commonly set between different signal formats of interleaved signals, and read the data elements written to the memory module from the memory module sequentially in accordance with address information in a specific reading order commonly set between the different signal formats, and output the read data elements as a restore signal.

According to still another embodiment, an interleaved signal restoring method performed by an authentication module, the interleaved signal restoring method comprises: receiving an interleaved signal; writing a plurality of data elements of the interleaved signal to a memory module sequentially in accordance with address information in a specific writing order commonly set between different signal formats of interleaved signals; reading the data elements written to the memory module from the memory module sequentially in accordance with address information in a specific reading order commonly set between the different signal formats; and outputting the read data elements as a restore signal.

In one embodiment, an authentication module will now be explained in detail with reference to the drawings.

The embodiment can be applied to an authentication module including a restoring module which restores an input interleaved signal to output, an electric device including the authentication module, and an interleaved signal restoring method performed by the authentication module. A television system to which the embodiment is applied will be explained below.

At first, the configuration of the television system is explained.

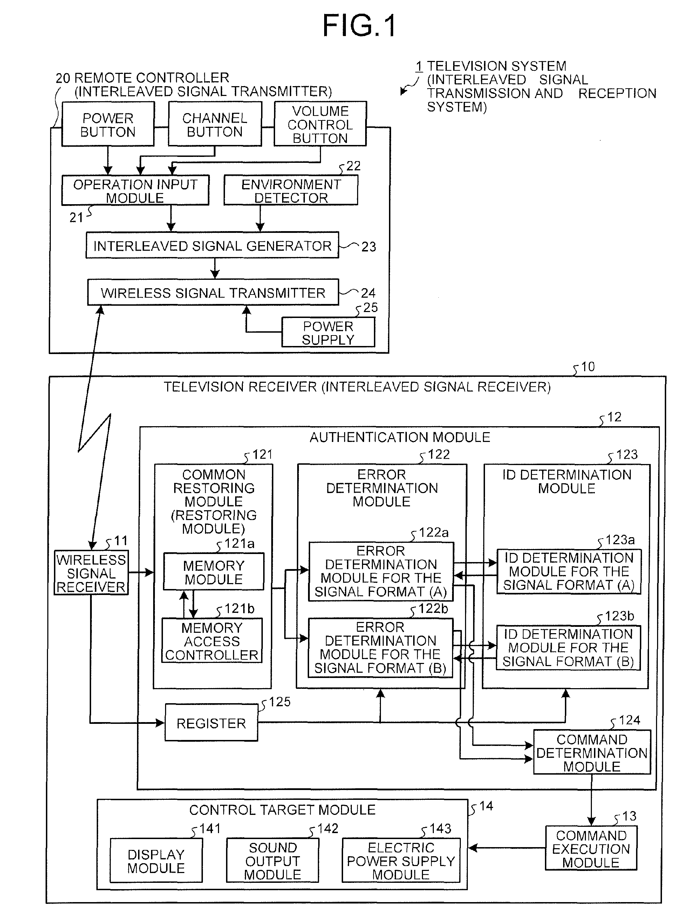

FIG. 1 is an exemplary block diagram of a television system in the embodiment.

As illustrated in FIG. 1, a television system 1 primarily includes a television receiver (an interleaved signal receiver) 10 which has a function to reproduce a video based on a signal received through a cable or using radio waves, and so on, and a remote controller (an interleaved signal transmitter) 20 to operate the operation of the television receiver 10 remotely.

In the embodiment, the remote controller 20 has a function to transmit a transmission signal including an ID, a command, an error detection code, and so on to be transmitted to the television receiver 10 as an interleaved signal having an optimal signal format selected from a plurality of signal formats in accordance with a condition of a communication environment. In an example illustrated in FIG. 1, the remote controller 20 comprises an operation input module 21, an environment detector 22, an interleaved signal generator 23, a wireless signal transmitter 24, a power supply 25, and so on.

The operation input module 21 inputs an operation signal from a variety of operation button such as a power button to turn on or off a power supply to cause the television receiver 10 to switch from an operating state from a standby state, a channel button used for selectively specifying one of channels "1" to "12", and a volume control button used for controlling volume of sound output from a speaker, and outputs the input operation signal to the interleaved signal generator 23 provided downstream to the operation input module 21.

The environment detector 22 detects a communication environment of the remote controller 20 (that is to say, the television receiver 10) at a predetermined timing such as, every fixed period, and outputs a selection signal (a selection signal (A) or a selection signal (B) described later) to select the optimal signal format of the signal formats (a signal format (A) or a signal format (B) described later) in accordance with the condition of the detected communication environment to the interleaved signal generator 23 provided downstream to the environment detector 22.

More specifically, when the environment detector 22 detects an environmental condition in which a similar type of device to that of the television receiver 10 exits around the remote controller 20 (the television receiver 10) by, for example, receiving a surrounding signal transmitted from a variety of device exiting around the remote controller 20, the environment detector 22 outputs the selection signal (A) to select the signal format (A) capable of preventing a malfunction of the similar type of device to the interleaved signal generator 23.

When the environment detector 22 detects an environmental condition that is in a high noise environment around the remote controller 20 (the television receiver 10) and there is a high possibility that a communication error occurs, the environment detector 22 outputs the selection signal (B) to select the signal format (B) robust to communication error to the interleaved signal generator 23.

The interleaved signal generator 23 generates the interleaved signal having the signal format (A) or the signal format (B) based on the signals input from the operation input module 21 and the environment detector 22.

More specifically, the interleaved signal generator 23 updates and holds the selection signal (A) or the selection signal (B) input at the predetermined timing from the environment detector 22. When the interleaved signal generator 23 inputs the operation signal from the operation input module 21, the interleaved signal generator 23 selects the signal format (A) or the signal format (B) corresponding to the selection signal (A) or the selection signal (B) held at that timing to generate the interleaved signal having the selected signal format.

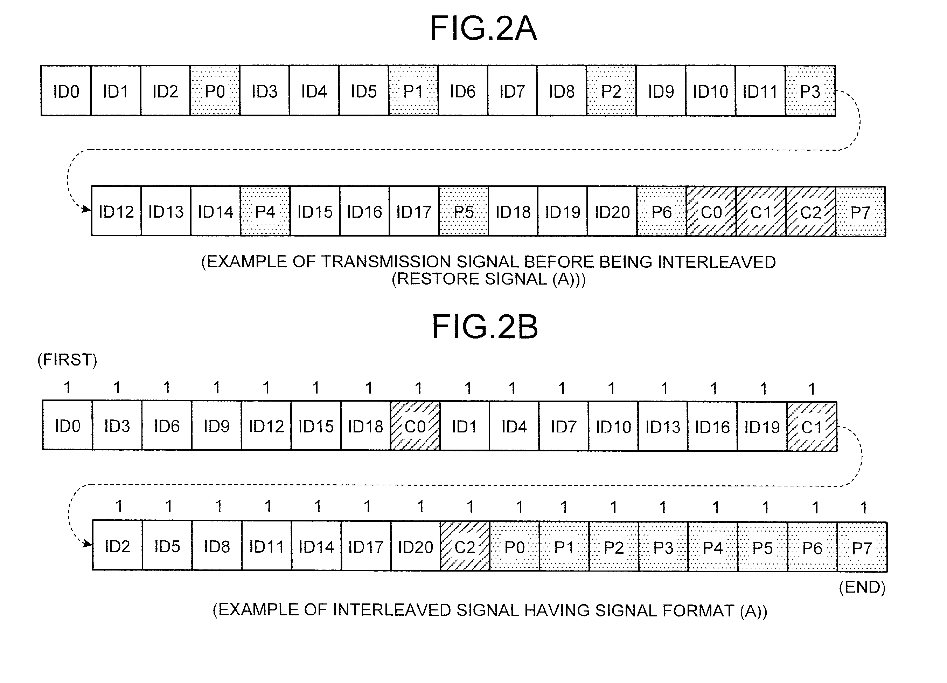

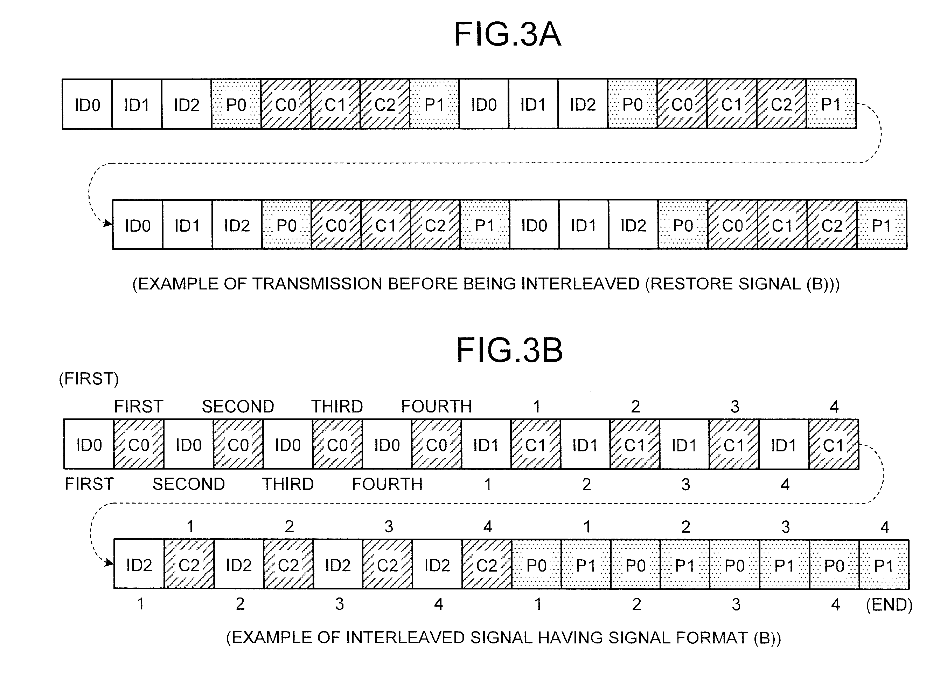

FIGS. 2A and 2B are exemplary diagrams for explaining a configuration of an interleaved signal having the signal format (A) generated by the interleaved signal generator 23. FIGS. 3A and 3B are diagrams for explaining a configuration of an interleaved signal having the signal format (B) generated by the interleaved signal generator 23.

More specifically, FIG. 2A is an exemplary diagram illustrating a transmission signal (an original signal) that is a state that an interleaved signal having the signal format (A) has not been generated yet, that is, on which a sort (an interleaving) has not been performed. FIG. 2B is an exemplary diagram illustrating an interleaved signal having the signal format (A), that is, the signal obtained by performing the sort (the interleaving) on the transmission signal(the original signal) illustrated in FIG. 2A.

FIG. 3A is an exemplary diagram illustrating a transmission signal (an original signal) that is a state that an interleaved signal having the signal format (B) has not been generated yet, that is, on which a sort (an interleaving) has not been performed. FIG. 3B is an exemplary diagram illustrating an interleaved signal having the signal format (B), that is, the signal obtained by performing the sort (the interleaving) on the transmission signal (the original signal) illustrated in FIG. 3A.

As illustrated in FIGS. 2A, 2B, 3A, and 3C, the interleaved signal generator 23 in the embodiment generates a transmission signal (an original signal) before being interleaved as illustrated in FIG. 2A or FIG. 3A before generating an interleaved signal having the signal format (A) or the signal format (B). After generating the transmission signal (the original signal), the interleaved signal generator 23 sorts data such as an ID, a command, and an error detection code of the generated transmission signal (original signal) in accordance with a specific data sorting rule commonly set between the signal formats (A) and (B) different from each other to generate the interleaved signal as illustrated in FIG. 2B or FIG. 3B.

Specifically, the specific data sorting rule is used to have an order of data in a state after sorting data such as the ID, the command, and the error detection code included in the transmission signal (the original signal) before being interleaved as illustrated in FIG. 2A or FIG. 3A to set commonly between the signal formats (A) and (B) different from each other.

For example, the first data (ID0) of the transmission signals (the original signals) in the state before being interleaved as illustrated in FIG. 2A and FIG. 3A are arranged in a different order based on the specific data sorting rule to be in the first area as illustrated in FIG. 2B and FIG. 3B. Similarly, the second data (ID1) of the transmission signals in the state before being interleaved as illustrated in FIG. 2A and FIG. 3A are arranged in a different order based on the specific data sorting rule to be in the ninth area as illustrated in FIG. 2B and FIG. 3B. Further, the third data (ID2) of the transmission signals in the state before being interleaved as illustrated in FIG. 2A and FIG. 3A are arranged in a different order based on the specific data sorting rule to be in the seventeenth area as illustrated in FIG. 2B and FIG. 3B.

As illustrated in FIG. 2B, in the interleaved signal having the signal format (A), long ID data, that is, many types of IDs are set and the same type of ID and command is used one time only. Therefore, the interleaved signal having the signal format (A) has a characteristic that has a strong authentication capability and does not have a high error correction capability to correct communication errors, and so on.

As illustrated in FIG. 3B, in the interleaved signal having the signal format (B), short ID data, that is, a few types of IDs are set and the same type of IDs and command are used multiple times. Therefore, the interleaved signal having the signal format (B) has a characteristic that has a weak authentication capability and has a high error correction capability to correct communication errors, and so on.

The interleaved signal generator 23 in the embodiment adds a single error detection code to predetermined number of data (such as the IDs and the commands) as a common data structure, regardless of the signal format (A) or the signal format (B), of the transmission signal (the original signal) in the state before being interleaved.

In the example of the transmission signal (the original signal) illustrated in FIG. 2A, the twenty-one types of IDs of ID0 to ID20 are arranged in a predetermined order, and after those IDs, the three types of commands of C1 to C3 are arranged in a predetermined order, and an error detection code associated with either of the three IDs or the three commands is added after the corresponding three IDs or the corresponding three commands.

In the example of the transmission signal (the original signal) illustrated in FIG. 3A, the three types of IDs of ID0 to ID2 are arranged in a predetermined order, and after those IDs, the three types of commands of C1 to C3 are arranged in a predetermined order, and a group in which an error detection code associated with either of the three IDs or the three commands is added after the corresponding three IDs or the corresponding three commands is repeated four times.

In the examples illustrated in FIGS. 2A and 3A, an error detection code is added to either of the three IDs (ID0, ID1, ID2, for example) or the three commands (C0, C1, C2, for example), but it is not limited to this. An error detection code can be added to either of the two or more than four IDs or the two or more than four commands.

Here, the ID is data indicating an identifier to authenticate if a signal is output from the authorized remote controller 20. The command is data indicating an operation command (a content of operation) of the television receiver 10. The error detection code is a code to detect an error of data such as the ID or the command.

When a signal format of an interleaved signal generated at this time is different from a signal format of an interleaved signal generated at the previous time, that is, a signal format is changed, the interleaved signal generator 23 outputs to the wireless signal transmitter 24 a change signal to notify that a signal format is changed and to change a setting of a register 125 included in the television receiver 10.

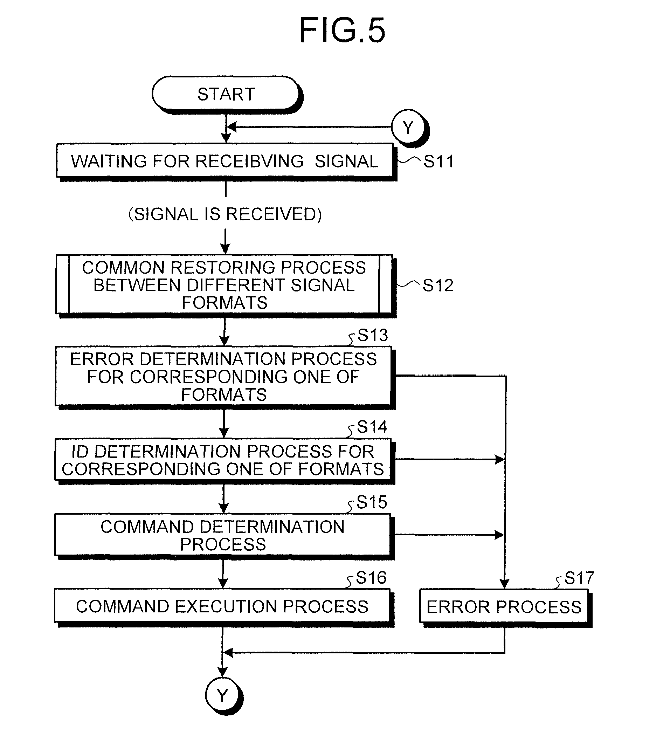

In the television system (an interleaved signal transmission and reception system) 1 of the embodiment, in order to cause all of the plurality types of the interleaved signals obtained by interleaving in different signal formats to be restored in a common restoring process (a process at S12 of FIG. 5) in a common restoring module (restoring module) 121 described later arranged at a side of the television receiver (the interleaved receiver) 10, the transmission signals (the original signals) in the state before being interleaved are supposed to be sorted in accordance with the specific data sorting rule commonly set between the different signal formats to generate the interleaved signals at a side of the remote controller (the interleaved signal transmitter) 20.

Referring back to FIG. 1, the wireless signal transmitter 24 transmits the interleaved signal generated by the interleaved signal generator 23 on a radio wave (a carrier wave) with wireless communication module such as the Bluetooth (registered trademark) module.

When the wireless signal transmitter 24 inputs the change signal from the interleaved signal generator 23, the wireless signal transmitter 24 transmits the input change signal through radio waves with the wireless communication module.

The power supply 25 supplies electric power needed for operations of the modules 21 to 24 from a power supply such as a dry battery and a storage battery.

The television receiver 10 in the embodiment has a function to restore the interleaved signal transmitted through radio waves from the remote controller 20. In the example illustrated in FIG. 1, the television receiver 10 comprises a wireless signal receiver 11, an authentication module 12, a command execution module 13, and a control target module 14.

Here, the wireless signal receiver 11 receives the radio waves transmitted from the wireless signal transmitter 24 of the remote controller 20 with a wireless communication module such as the Bluetooth module, and extracts the interleaved signal from the received radio waves to output to the authentication module 12 provided downstream to the wireless signal receiver 11.

The authentication module 12 includes the common restoring module (the restoring module) 121, an error determination module 122, an ID determination module 123, a command determination module 124, and the register 125. The authentication module 12 performs an authentication process such as the restoring process, an error determination process, an ID determination process, and a command determination process on the input interleaved signal, using those modules 121 to 125.

Here, the common restoring module 121 performs the restoring process on the interleaved signal (See FIGS. 2B and 3B) input from the wireless signal receiver 11 to the transmission signal (the original signal) in the state before being interleaved (See FIGS. 2A and 3A).

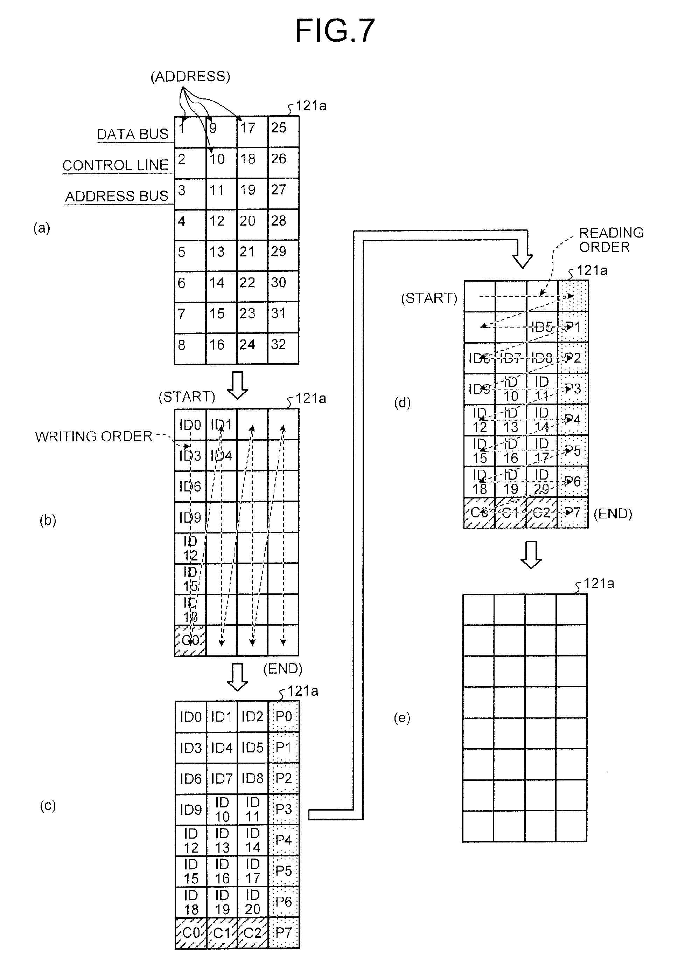

The common restoring module 121 in the embodiment primarily includes a memory module 121a (See (a) of FIG. 7) and a memory access controller 121b. The memory module 121a has a two-dimensional lattice array of memory cells arranged in rows and columns, the memory cells storing a plurality of element data (the IDs, the commands, the error detection codes, and so on) of the interleaved signal, respectively. Each of the element data is bit-oriented data. That is to say, each of the memory cells stores the corresponding one, which is bit-oriented data, of the data elements. The memory access controller 121b writes and reads the data elements to/from the memory module 121a through a data bus, a control line, and an address bus, and so on (see (a) of FIG. 7).

Here, when the interleaved signal is input, the memory access controller 121b in the embodiment writes the data elements of the input interleaved signal to the memory module 121a sequentially in accordance with address information in a specific writing order commonly set between the different signal formats of the interleaved signals, and reads the data elements written to the memory module 121a from the memory module 121a sequentially in accordance with the address information in a specific reading order commonly set between the different signal formats, and outputs the data elements read by the memory access control as a restore signal (that is, the transmission signal(the original signal) in the state before being interleaved).

The address information in the specific writing order is first address information to specify the memory cells of the addresses to which the data elements from beginning to end of the input interleaved signal are written respectively.

The address information in the specific reading order is second address information to specify the memory cells of the addresses from which the data elements written to the memory cell based on the first address information are read respectively in order. That is to say, the specific writing order and the specific reading order are set in response to the specific data sorting rule.

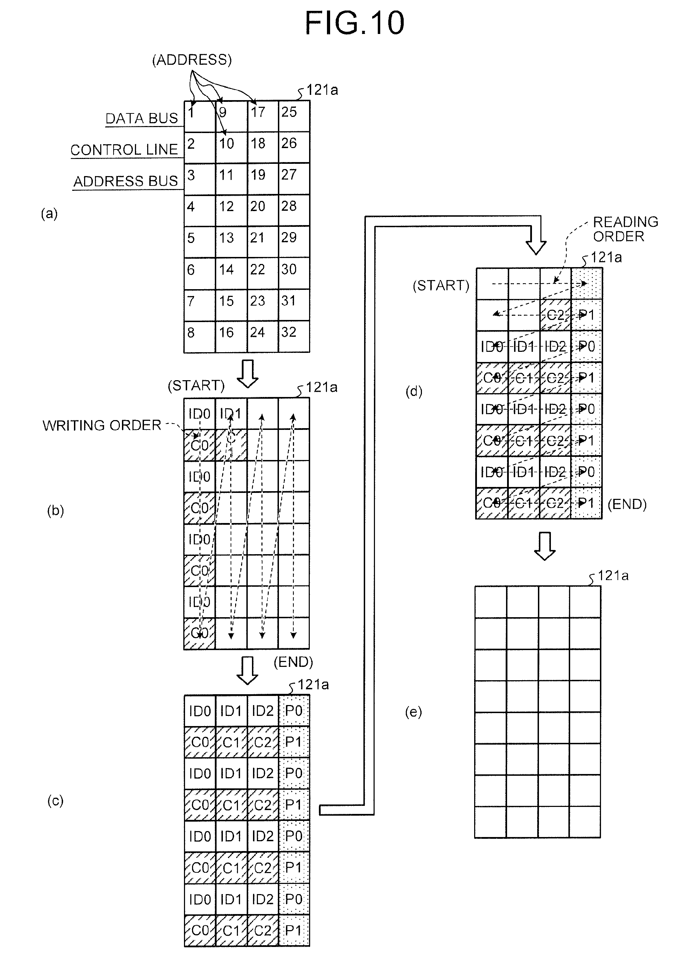

Specifically, in the embodiment, when the data elements of the input interleaved signal are written to the memory cells of the memory module 121a respectively, the data elements are written sequentially in order in a longitudinal direction, that is, in a column direction of the memory module 121a (See (b) of FIG. 7 and (b) of FIG. 10). Thus, in the first address information, the address of the writing order is set in which the data elements are written, at first, from the address (1) of the memory cell in the top row of the leftmost column to the address (8) of the memory cell in the bottom row of the leftmost column, in the second place, from the address (9) of the memory cell in the top row of the second leftmost column to the address (16) of the memory cell in the bottom row of the second leftmost column, ... in the last place, from the address (25) of the memory cell in the top row of the rightmost column to the address (32) of the memory cell in the bottom row of the rightmost column ("1→2→3→4→5→6→7→8→9→10→·····→29→30→31→32") (See the addresses in (a) of FIG. 7).

Also, in the embodiment, when the data elements written to the memory cells of the memory module 121a are read sequentially, the data elements are read sequentially in order in a lateral direction, that is, in a row direction of the memory module 121a (See (d) of FIG. 7 and (d) of FIG. 10). Thus, in the second address information, the address of the reading order is set in which the data elements are read, at first, from the address (1) of the memory cell of the leftmost column in the top row to the address (25) of the memory cell in the rightmost column in the top row, in the second place, from the address (2) of the memory cell of the leftmost column in the second top row to the address (26) of the memory cell in the rightmost column of the second top row, ... in the last place, from the address (8) of the memory cell in the leftmost column of the bottom row to the address (32) of the memory cell in the rightmost column of the bottom row ("1→9→17→25→2→10→18→26→3→·····→8→16→24→32") (See the addresses in (a) of FIG. 7).

The common restoring module 121 in the embodiment is realized with an integrated circuit with which electronic circuits such as IC (Integrated Circuit) and LSI (Large Integrated Circuit) are integrated.

The error determination module 122 determines whether an error is included in the data obtained by restoring by the common restoring module 121 with a error detection code, and if the data satisfies a predetermined condition, the error determination module 122 outputs the ID data which satisfies the predetermined condition to the ID determination module 123 provided downstream to the error determination module 122, and outputs the command data which satisfies the predetermined condition to the command determination module 124 provided downstream to the error determination module 122.

More specifically, the error determination module 122 includes the error determination module for the signal format (A) 122a which performs the error determination process on the signal having the signal format (A), and the error determination module for the signal format (B) 122b which performs the error determination process on the signal having the signal format (B).

Specifically, the error determination module for the signal format (A) 122a performs a predetermined error check such as an error check by 4 bits, and if no error is included in the plurality types of IDs and commands, the error determination module for the signal format (A) 122a outputs the input ID data to the ID determination module 123. If the error determination module for the signal format (A) 122a inputs a report signal indicating that the ID data is authorized from the ID determination module 123, the error determination module for the signal format (A) 122a outputs the input command data to the command determination module 124.

On the other hand, if an error is included in at least one of the plurality types of IDs and commands as a result of the error check, the error determination module for the signal format (A) 122a determines that an error is included in the ID data and the command data and normal data cannot be received, and performs an error process. That is to say, the error determination module for the signal format (A) 122a discards the ID data and the command data without outputting the ID data to the ID determination module 123 and outputting the command data to the command determination module 124.

The error determination module for the signal format (B) 122b performs a predetermined error check such as an error check by 4 bits, and if no error is included in both at least one of a plurality of first groups each of which is composed of all the few type of IDs and at least one of a plurality of second groups each of which is composed of all the few type of commands, the error determination module for the signal format (B) 122b outputs the ID data corresponding the first group having no error to the ID determination module 123. If the error determination module for the signal format (B) 122b inputs a report signal indicating that the ID data is authorized from the ID determination module 123, the error determination module for the signal format (B) 122b outputs the command data corresponding the second group having no error to the command determination module 124.

On the other hand, if there is no case that no error is included in both at least one of the first groups each of which is composed of all the few type of IDs and at least one of the second groups each of which is composed of all the few type of commands as a result of the error check, the error determination module for the signal format (B) 122b determines that an error is included in the ID data and the command data and normal data cannot be received, and performs an error process. That is to say, the error determination module for the signal format (B) 122b discards the ID data and the command data without outputting the ID data to the ID determination module 123 and outputting the command data to the command determination module 124.

When the ID determination module 123 determines that the ID data input from the error determination module 122 is identical to a registered authorized ID data, the ID determination module 123 outputs the report signal to the error determination module 122 provided upstream to the ID determination module 123.

When the command determination module 124 determines that the command data input from the error determination module 122 is identical to a registered authorized command data, the command determination module 124 outputs the command data to the command execution module 13 provided downstream to the command determination module 124.

When the register 125 inputs the change signal transmitted from the wireless signal transmitter 24 of the remote controller 20 through the wireless signal receiver 11, the register 125 changes a register setting.

Specifically, the register 125 outputs to the error determination module 122 a select signal to select the error determination module for the signal format (A) 122a or the error determination module for the signal format (B) 122b in association with the signal format ((A) or (B)) of the interleaved signal to be processed at this time. Further, the register 125 outputs to the ID determination module 123 a select signal to select an ID determination module for the signal format (A) 123a or an ID determination module for the signal format (B) 123b in association with the signal format ((A) or (B)) of the interleaved signal to be processed at this time.

The command execution module 13 executes the input command. More specifically, if the input command is a command to turn on a power supply, the command execution module 13 controls an electric power supply module 143 to supply electric power to each module of the television receiver 10. If the input command is a command to control a sound volume, the command execution module 13 controls a sound output module 142 to control the sound volume.

The control target module 14 is a controlled module controlled by the command executed by the command execution module 13. For example, the control target module 14 includes a display module 141 to display a television image with a LED display and so on, the sound output module 142 to output television audio with a speaker and so on, and the electric power supply module 143 to supply necessary electric power to each module (11 to 13, 141, 142 and so on) from a commercial power supply.

Next, process operations of when the interleaved signal is transmitted and received in the television system 1 are explained below.

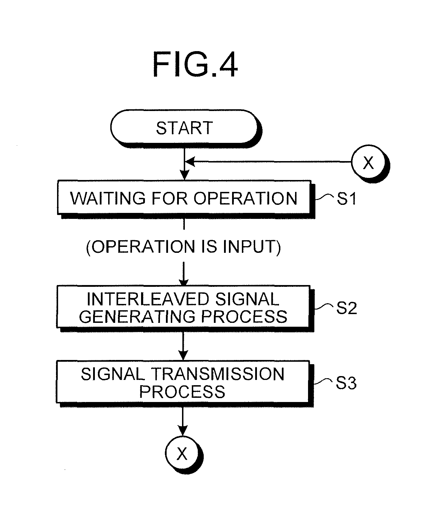

FIG. 4 is a flowchart of the interleaved signal transmission processing in the remote controller 20.

As illustrated in FIG. 4, in the remote controller 20, when the operation input module 21 detects a pressing operation by a user of the variety of operation button such as the power button, the channel button, and the volume control button in a waiting for an operation at S1, the operation input module 21 outputs the operation signal corresponding to the detected pressing operation to the interleaved signal generator 23.

After that, at S2, the interleaved signal generator 23 selects one of the signal format (A) and the signal format (B) based on the selection signal (A) or the selection signal (B) input from the environment detector 22 at the predetermined timing, and generates the interleaved signal obtained by interleaving in the selected signal format (See FIGS. 2B and 3B and so on) to output to the wireless signal transmitter 24.

At S2, when the signal format of the interleaved signal generated at this time is different from the signal format of the interleaved signal generated at the previous time, that is, the signal format is changed, the interleaved signal generator 23 outputs the change signal (the signal notify that the signal format is changed) to the wireless signal transmitter 24.

After that, at S3, the wireless signal transmitter 24 which has input the interleaved signal transmits the input interleaved signal through radio waves with the wireless communication module.

Also at S3, when the wireless signal transmitter 24 inputs the change signal from the interleaved signal generator 23, the wireless signal transmitter 24 transmits the change signal (the signal to change the setting of the register 125) through radio waves.

FIG. 5 is a flowchart of the interleaved signal reception processing in the television receiver 10.

As illustrated in FIG. 5, in the television receiver 10, when the wireless signal receiver 11 receives the radio wave transmitted from the remote controller (the interleaved signal transmitter) 20 in a waiting for receiving a signal at S11, the wireless signal receiver 11 extracts the interleaved signal (FIGS. 2B and 3B and so on) from the radio wave to output to the common restoring module 121 of the authentication module 12.

After that, at S12, the common restoring module 121 performs the restoring process commonly set between the different signal formats.

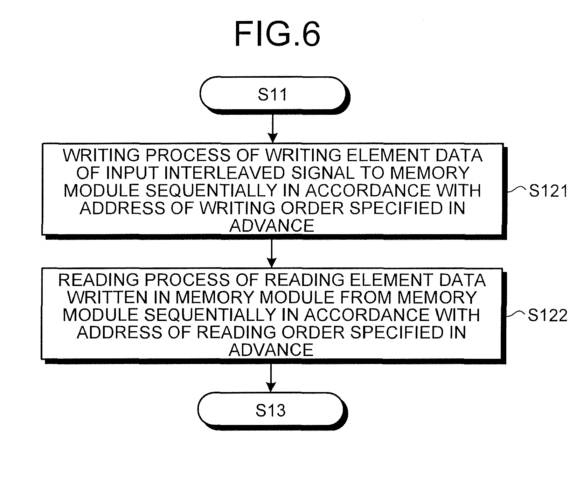

FIG. 6 is a flowchart of the restoring process in S12 of FIG. 5.

As illustrated in FIG. 6, in the restoring process, at first, at S121, the data elements such as the IDs, the commands, the error detection codes included in the input interleaved signal are written to the memory module 121a sequentially in accordance with the address information in the specific writing order (the first address information) commonly set between the different signal formats ((A), (B)).

After that, at S122, the data elements written to the memory module 121a are read from the memory module 121a sequentially in accordance with the address information in the specific reading order (the second address information) commonly set between the different signal formats ((A), (B)).

After that, referring beck to FIG. 5, at S13, the error determination module 122 performs the error determination process for corresponding one of the signal formats based on the setting of the register 125. As a result of the error determination process, when the error determination module 122 determines that normal signal data (the ID and the command) has been received, the error determination module 122 outputs the normal signal data to the ID determination module 123.

Subsequently, at S14, the ID determination module 123 performs the ID determination process for corresponding one of the signal formats based on the setting of the register 125. That is to say, the ID determination module 123 determines whether the input ID data is identical to the ID data registered in advance, and if it is identical to that, the ID determination module 123 outputs the report signal indicating that the ID data is an authorized ID data to the error determination module 122. In response to the report signal, the error determination module 122 outputs the command data to the command determination module 124.

After that, at S15, the command determination module 124 determines whether the input command data is identical to the command data registered in advance, and if it is identical to that, the command determination module 124 outputs the command data to the command execution module 13.

Subsequently, at S16, the command execution module 13 executes the input command.

In the process at S13, when the normal ID data and command data is not received, the process proceeds to S17 to perform the error process. Specifically, as the error process, the error determination module 122 discards the input ID data and command data without outputting to the ID determination module 123 and the command determination module 124 provided downstream to the error determination module 122.

In the process at S14, when the input ID data is not identical to the ID data registered in advance, the process proceeds to S17 to perform the error process. Specifically, as the error process, the ID determination module 123 outputs the report signal indicating that the ID data is not an authorized ID data to the error determination module 122. In response to the report signal, the error determination module 122 discards the input command data without outputting to the command determination module 124.

In the process at S15, when the input command data is not identical to the command data registered in advance, the process proceeds to S17 to perform the error process. Specifically, as the error process, the command determination module 124 discards the input command data.

An authentication process of the interleaved signal having the signal format (A) illustrated in FIG. 2B and an authentication process of the interleaved signal having the signal format (B) illustrated in FIG. 3B as a concrete process of the authentication process (S12 to S15) of FIG. 5 are explained below with reference to FIGS. 7 to 12 in addition to FIGS. 2A, 2B, 3A, and 3B.

At first, the authentication process of the interleaved signal having the signal format (A) illustrated in FIG. 2B is explained.

In the process at S12, when the common restoring module 121 inputs the interleaved signal having the signal format (A) as illustrated in FIG. 2B from the wireless signal receiver 11, the common restoring module 121 writes the data elements of the input interleaved signal sequentially in order from the first one (ID0) of the data elements of the input interleaved signal (See FIG. 2B) to the memory module 121a in an empty state as illustrated in (a) of FIG. 7 in the longitudinal direction (a dotted arrow direction) as illustrated in (b) of FIG. 7.

As illustrated in (c) of FIG. 7, when the writing of all the data elements are completed, the common restoring module 121 reads the data elements written to the memory module 121a sequentially in order in the lateral direction (a dotted arrow direction) as illustrated in (d) of FIG. 7. As illustrated in (e) of FIG. 7, when the reading of all the data elements are completed, the restore signal (A) (that is, the transmission signal (the original signal) in the state before being interleaved) as illustrated in FIG. 2A is obtained.

The common restoring module 121 outputs the restore signal (A) to the error determination module 122.

After that, in the process at S13, the error determination module for the signal format (A) 122a performs error check on the input restore signal (A) with the error detection code.

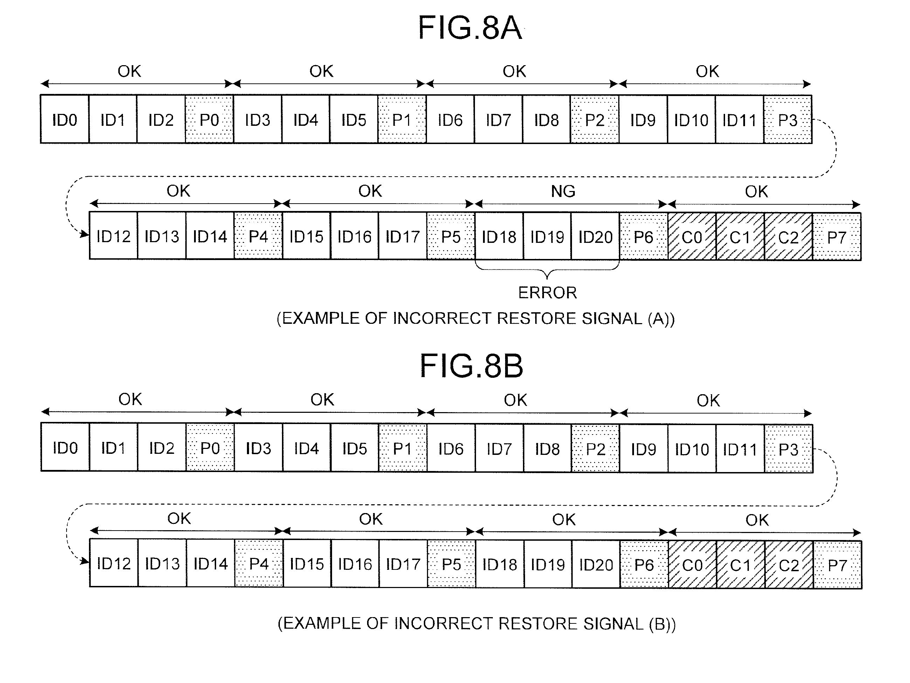

Specifically, in this error check, as illustrated in FIG. 8A, if an error is detected even in one of each of the ID data or the command data, the error determination module for the signal format (A) 122a determines that the ID data or the command data is not normal, that is, the normal restore signal is not obtained, and performs the error process at S17.

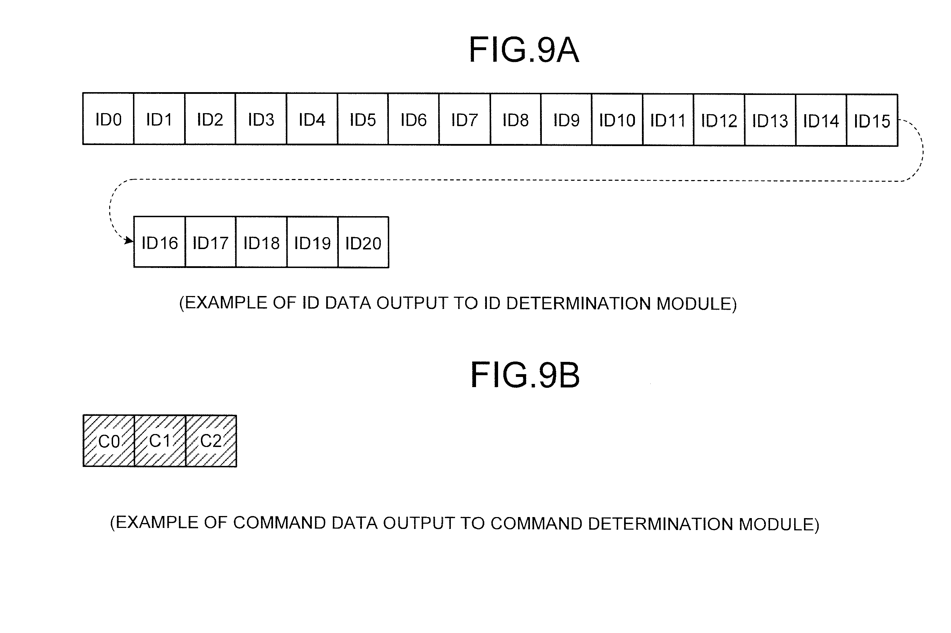

On the other hand, in this error check, as illustrated in FIG. 8B, only when no error is detected even in one of each of the ID data or the command data, the error determination module for the signal format (A) 122a outputs the ID data in which only the ID data extracted from the restore signal (A) is included to the ID determination module 123 as illustrated in FIG. 9A.

After that, in the process at S14, the ID determination module for the signal format (A) 123a determines whether the input ID data (FIG. 9A) is identical to the authorized ID data registered in advance.

In this case, if the ID determination module for the signal format (A) 123a determines that the input ID data is identical to the authorized ID data, the ID determination module for the signal format (A) 123a outputs the report signal indicating that the input ID data is authorized to the error determination module for the signal format (A) 122a. In response to the report signal, the error determination module for the signal format (A) 122a outputs the command data in which only the command data extracted from the restore signal (A) is included to the command determination module 124 as illustrated in FIG. 9B.

Subsequently, in the process at S15, the command determination module 124 determines whether the input command data (FIG. 9B) is identical to the authorized command data registered in advance. If the command determination module 124 determines that the input command data is identical to the authorized command data, the command determination module 124 outputs the command data to the command execution module 13. Thus, in the next process at S16, the command execution module 13 executes the input command.

Next, the authentication process of the interleaved signal having the signal format (B) illustrated in FIG. 3B is explained.

In the process at S12, when the common restoring module 121 inputs the interleaved signal having the signal format (B) as illustrated in FIG. 3B from the wireless signal receiver 11, the common restoring module 121 writes the data elements of the input interleaved signal sequentially in order from the first one (ID0) of the data elements of the input interleaved signal (See FIG. 2B) to the memory module 121a in an empty state as illustrated in (a) of FIG. 10 in the longitudinal direction (a dotted arrow direction) as illustrated in (b) of FIG. 10.

As illustrated in (c) of FIG. 10, when the writing of all the data elements are completed, the common restoring module 121 reads the data elements written to the memory module 121a sequentially in order in the lateral direction (a dotted arrow direction) as illustrated in (d) of FIG. 10. As illustrated in (e) of FIG. 10, when the reading of all the data elements are completed, the restore signal (B) (that is, the transmission signal (the original signal) in the state before being interleaved) as illustrated in FIG. 3A is obtained.

The common restoring module 121 outputs the restore signal (B) to the error determination module 122.

After that, in the process at S13, the error determination module for the signal format (B) 122b performs error check on the input restore signal (B) with the error detection code.

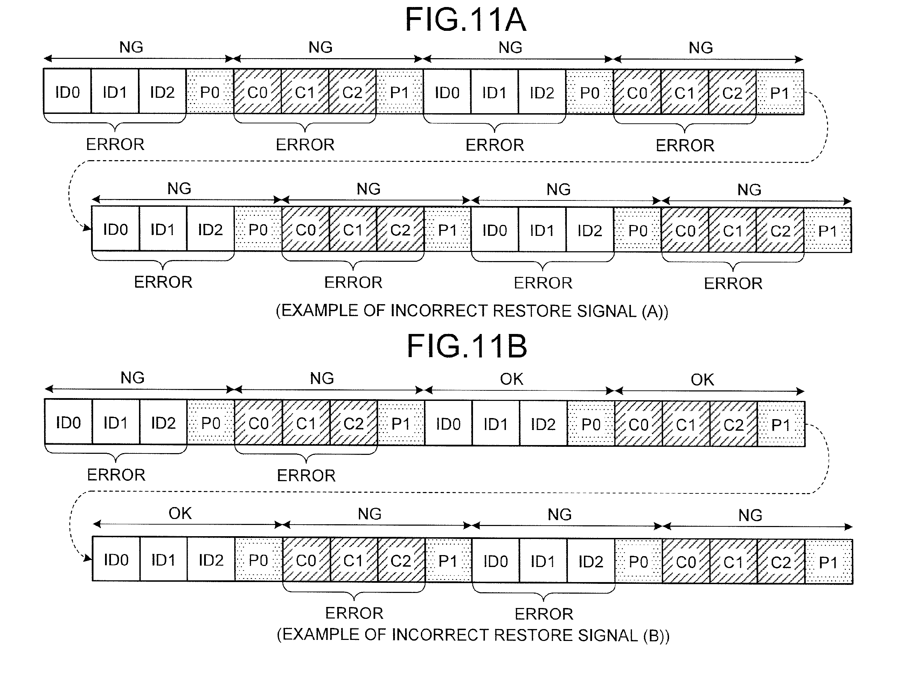

Specifically, in this error check, as illustrated in FIG. 11A, if a normal first group having no error does not exist among the plurality of first groups each of which is composed of a bunch of IDs (ID0 to ID2) and is repeated multiple times and a normal second group having no error does not exist among the plurality of second groups each of which is composed of a bunch of commands (C0 to C2) and is repeated multiple times, the error determination module for the signal format (B) 122b determines that the ID data and the command data are not normal, that is, the normal restore signal is not obtained, and performs the error process at S17.

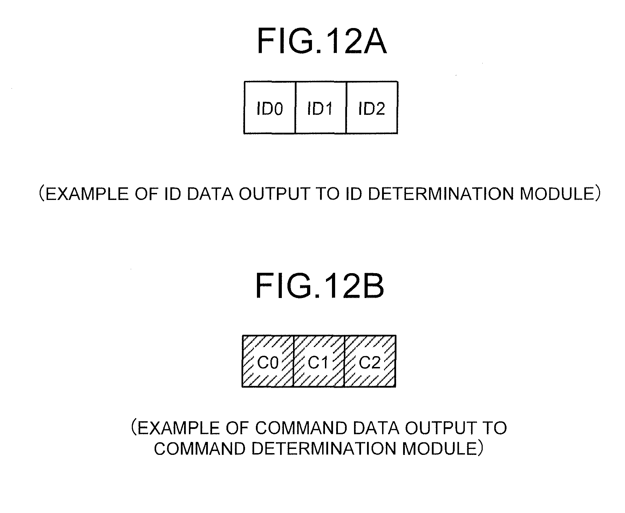

On the other hand, in this error check, as illustrated in FIG. 11B, if at least one normal first group having no error exists among the plurality of first groups each of which is composed of the bunch of IDs (ID0 to ID2) and is repeated multiple times and at least one normal second group having no error exists among the plurality of second groups each of which is composed of a bunch of commands (C0 to C2) and is repeated multiple times, the error determination module for the signal format (B) 122b outputs the ID data in which only the ID data extracted from the restore signal (B) is included to the ID determination module 123 as illustrated in FIG. 12A.

After that, in the process at S14, the ID determination module for the signal format (B) 123b determines whether the input ID data (FIG. 12A) is identical to the authorized ID data registered in advance.

In this case, if the ID determination module for the signal format (B) 123b determines that the input ID data is identical to the authorized ID data, the ID determination module for the signal format (B) 123b outputs the report signal indicating that the input ID data is authorized to the error determination module for the signal format (B) 122b. In response to the report signal, the error determination module for the signal format (B) 122b outputs the command data in which only the command data extracted from the restore signal (B) is included to the command determination module 124 as illustrated in FIG. 12B.

Subsequently, in the process at S15, the command determination module 124 determines whether the input command data (FIG. 12B) is identical to the authorized command data registered in advance. If the command determination module 124 determines that the input command data is identical to the authorized command data, the command determination module 124 outputs the command data to the command execution module 13. Thus, in the next process at S16, the command execution module 13 executes the input command.

According to the above explained embodiment, because a plurality types of interleaved signals obtained by interleaving in different signal formats can be restored by the same restoring module, it is possible to downsize an authentication module (a mounted module) on which the restoring module is mounted, and an electric device (a television receiver, for example) on which the authentication module is mounted. Thus, manufacturing costs of the authentication module (the mounted module) and the electric device (the television receiver, for example) can be reduced.

The embodiment is explained as an example, but it is not limited to this.

For example, in the embodiment, the memory access controller 121b of the common restoring module 121 writes the data elements of the input interleaved signal sequentially in order in the longitudinal direction (the column direction) of the memory module 121a, and reads the data elements written to the memory cells of the memory module 121a sequentially in order in the lateral direction (the row direction). However, instead of this, the memory access controller 121b can write the data elements of the input interleaved signal sequentially in order in the lateral direction (the row direction) of the memory module 121a, and read the data elements written to the memory module 121a sequentially in order in the longitudinal direction (the column direction).

Further, the memory access controller 121b has only to write each the data elements of the interleaved signal input in the common restoring module 121 from the first one to the end one of the data elements in accordance with the address of the corresponding memory cell specified in advance, and read each of the written data elements in accordance with the address of the corresponding memory cell specified in advance. Therefore, an address specifying method can be used other than the above mentioned address specifying method in which the data elements are written to and read from consecutive memory cells such as in the longitudinal direction (the column direction) or in the lateral direction (the row direction) of the memory module 121a.

In the above mentioned embodiment, when the environment detector 22 detects an environmental condition in which a similar type of device to that of the television receiver 10 exits around the television receiver 10, the environment detector 22 outputs the selection signal (A) to select the signal format (A) to the interleaved signal generator 23 provided downstream to the environment detector 22, and when the environment detector 22 detects an environmental condition that is in a high noise environment around the television receiver 10 and there is a high possibility that a communication error occurs, the environment detector 22 outputs the selection signal (B) to select the signal format (B) to the interleaved signal generator 23 provided downstream to the environment detector 22. Instead of this, for example, when the environment detector 22 detects an environmental condition that is in a high noise environment around the television receiver 10 and there is a high possibility that a communication error occurs, the environment detector 22 may output the selection signal (B) to select the signal format (B) to the interleaved signal generator 23 provided downstream to the environment detector 22, and when the environment detector 22 does not detect an environmental condition that there is a high possibility that the communication error occurs, that is , when in a normal state, the environment detector 22 may output the selection signal (A) to select the signal format (A) to the interleaved signal generator 23 provided downstream to the environment detector 22.

In the above mentioned embodiment, the wireless signal transmitter 24 transmits the signal generated by the interleaved signal generator 23 with the predetermined wireless communication module such as the Bluetooth module. Instead of this, for example, another wireless communication module such as a wireless LAN module and an infrared ray module can be used.

In the above mentioned embodiment, only the ID data is output from the error determination module 122 to the ID determination module 123, and only the command data is output from the error determination module 122 to the command determination module 124. Instead of this, for example, both the ID data and the command data may be output from the error determination module 122 to the ID determination module 123, and if the ID determination module 123 determined that the ID data is authorized, the command data may be output from the ID determination module 123 to the command determination module 124.

In the above mentioned embodiment, the common restoring module 121 can restore the interleaved signals in the two types of signal formats (A) and (B) in common. Instead of this, the common restoring module 121 can restore interleaved signals in the three types of signal formats in common.

In the above mentioned embodiment, the interleaved signal transmission and reception system is applied to the television system 1, the interleaved signal transmitter is applied to the remote controller, and the interleaved signal receiver is applied to the television receiver. Instead of this, for example, the interleaved signal transmitter can be applied to another device such as a mobile phone and a personal computer (PC), the interleaved signal receiver can be applied to another device such as a recording device and a DVD (Digital Versatile Disc) player.

Moreover, the various modules of the systems described herein can be implemented as software applications, hardware and/or software modules, or components on one or more computers, such as servers. While the various modules are illustrated separately, they may share some or all of the same underlying logic or code.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. An authenticate module (12) comprising:
a memory module (121a) that a plurality of data elements of an input interleaved signal are written to and read from; and
a memory access controller (121b) configured to write the data elements of the input interleaved signal to the memory module (121a) sequentially in accordance with address information in a specific writing order commonly set between different signal formats of interleaved signals, and read the data elements written to the memory module (121a) from the memory module (121a) sequentially in accordance with address information in a specific reading order commonly set between the different signal formats, and output the read data elements as a restore signal.

2. The authentication module (12) of Claim 1, wherein
the memory module (121a) comprises a two-dimensional lattice of memory cells arranged in rows and columns, the memory cells configured to store the data elements, respectively, each of which is bit-oriented data, and
the memory access controller (121b) is configured to write a predetermined number of the data elements of the input interleaved signal sequentially by a predetermined number of memory cells in either one direction of a row direction and a column direction repeatedly, and read the data elements written to the memory cells sequentially by a predetermined number of memory cells in a different direction from the one direction repeatedly after all of the data elements are written.

3. The authentication module (12) of Claim 1 or 2, wherein
a plurality types of the interleaved signals are signals resulting from sorting signals before being interleaved in accordance with a specific data sorting rule commonly set between the different signal formats.

4. The authentication module (12) of any one of Claims 1 to 3, further comprising:
an error determination module (122) configured to perform error determination process for corresponding one of the signal formats on the restore signal output from a common restoring module (121) based on a predetermined setting of a register (125);
an ID determination module (123) configured to perform ID determination process for the one of the signal formats on ID data included in the restore signal based on the setting of the register (125) when the error determination module (122) determines that a correct data is received; and
a command determination module (124) configured to perform command determination process on command data included in the restore signal when the ID determination module (123) determines that the ID data is authorized.

5. An electric device (10) comprising:
a memory module (121a) that a plurality of data elements of an input interleaved signal are written to and read from; and
a memory access controller (121b) configured to write the data elements of the input interleaved signal to the memory module (121a) sequentially in accordance with address information in a specific writing order commonly set between different signal formats of interleaved signals, and read the data elements written to the memory module (121a) from the memory module (121a) sequentially in accordance with address information in a specific reading order commonly set between the different signal formats, and output the read data elements as a restore signal.

6. An interleaved signal restoring method performed by an authentication module (12), the interleaved signal restoring method comprising:
receiving an interleaved signal;
writing a plurality of data elements of the interleaved signal to a memory module (121a) sequentially in accordance with address information in a specific writing order commonly set between different signal formats of interleaved signals;
reading the data elements written to the memory module (121a) from the memory module (121a) sequentially in accordance with address information in a specific reading order commonly set between the different signal formats; and
outputting the read data elements as a restore signal.
